(19)

Europäisches
Patentamt
European
Patent Office
Office européen
des brevets

(11)    **EP 4 549 983 A1**

(12)    **EUROPEAN PATENT APPLICATION**

(43) Date of publication:
**07.05.2025  Bulletin 2025/19**

(21) Application number: **24158606.4**

(22) Date of filing: **20.02.2024**

(51) International Patent Classification (IPC):
**G01R 33/56** (2006.01)    **G06N 3/0455** (2023.01)

(52) Cooperative Patent Classification (CPC):
**G01R 33/5608; G06N 3/0455**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **01.11.2023  EP 23207323**

(71) Applicant: **Koninklijke Philips N.V.
5656 AG Eindhoven (NL)**

(72) Inventors:
- **DONEVA, Mariya Ivanova
Eindhoven (NL)**

- **MEINEKE, Jan Jakob
Eindhoven (NL)**
- **VAN OSCH, Matthias Johannes Paulus
5656AG Eindhoven (NL)**
- **RAO, Chinmay
Eindhoven (NL)**
- **STARING, Marius
Eindhoven (NL)**
- **DE WEERDT, Elwin
5656AG Eindhoven (NL)**
- **PEZZOTTI, Nicola
5656AG Eindhoven (NL)**

(74) Representative: **Philips Intellectual Property &
Standards
High Tech Campus 52
5656 AG Eindhoven (NL)**

(54)    **RECONSTRUCTION OF MAGNETIC RESONANCE IMAGES USING AUTOENCODERS**

(57)    Disclosed is magnetic resonance imaging method using an autoencoder neural network (114, 500, 702, 800, 900) configured to output a target magnetic resonance image (124) in response to receiving a reference magnetic resonance image (116) and a style magnetic resonance image (122). The method comprises: receiving (200) the reference magnetic resonance image, receiving (202) measured k-space data (118), reconstructing (204) a measured magnetic resonance image (120) as the style magnetic resonance image. The method further comprises performing the following iteratively: receiving (208) the target magnetic resonance image, calculating (210) target k-space data (126), generating (212) intermediate k-space data (128) from the measured k-space data and the target k-space data, and reconstructing (214) an intermediate magnetic resonance image (130) as the style magnetic resonance image for the iterative loop. The method further comprises providing (218) the intermediate magnetic resonance image upon termination (132, 410, 414) of the iterative loop.

```
                                                                    200
       receive the reference magnetic resonance image
                              │                                     202
            receive measured k-space data
                              │                                     204
    reconstruct a measured magnetic resonance image from the
                   measured k-space data
                              │                                     206
    provide the measured magnetic resonance image as the style
                 magnetic resonance image
                              │                                     208
     receive the target magnetic resonance image in response to
 ┌─→ inputting the reference magnetic resonance image and the style
 │   magnetic resonance image into the autoencoder neural network
 │                            │                                     210
 │    calculate target k-space data by Fourier transforming the target
 │                  magnetic resonance image
 │                            │                                     212
 │   generate intermediate k-space data by comparing the measured
 │                k-space data and the target k-space data
 │                            │                                     214
 │   reconstruct an intermediate magnetic resonance image from the
 │                  intermediate k-space data
 │                            │                                     216
 │    use the intermediate magnetic resonance image as the style
 │            magnetic resonance image for the iterative loop
 │                            │                                     218
 │   No                iterative loop
 └─────────────────    finished?
                              │ Yes                                 220
    provide the intermediate magnetic resonance image as a clinical
    magnetic resonance image upon termination of the iterative loop
```

Fig. 2

EP 4 549 983 A1

**Description**

FIELD OF THE INVENTION

The invention relates to magnetic resonance imaging, in particular to the reconstruction of magnetic resonance images.

BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. During a magnetic resonance imaging scan or procedure, various magnetic field gradients and Radio-Frequency (RF) pulses are applied to the nuclear spins which then emit RF signals. The RF signals are sampled at various points and recorded. These samples are measurements made in k-space and are referred to as k-space data. There exists a large variety of magnetic resonance imaging protocols which use different k-space sampling patterns.

Chinese patent publication CN112700508A discloses a multi-contrast MRI image reconstruction method based on deep learning, relating to the technical field of medical image processing, a training set sample is formed by collecting a real full-sampling MRI image and a reconstructed MRI image sampled randomly in a K-space, a deep convolutional neural network is trained, then the undersampled MRI images with different contrasts are used as input, the primary fully sampled MRI images with different contrasts are output, the encoder extracts the structural features and contrast features of the primary fully sampled MRI images with different contrasts and then carries out similarity constraint, finally, the generator generates the final complete MRI images with different contrasts, the defect that most of the current models are reconstructed only by using the MRI images with single contrast is overcome, but the utilization of multi-contrast MRI image related information is lacked for reconstruction, so that the reconstruction quality of the MRI image is improved, and the reliability of the diagnosis result of the medical system is ensured.

SUMMARY OF THE INVENTION

The invention provides for a medical system, a magnetic resonance imaging method, and a computer program in the independent claims. Embodiments are given in the dependent claims.

In one aspect a medical system is disclosed. The medical system comprises a memory storing machine-executable instructions and an autoencoder neural network. The autoencoder neural network is configured to output a target magnetic resonance image with a second magnetic resonance imaging image weighting in response to receiving a reference magnetic resonance image and a style magnetic resonance image as input. The reference magnetic resonance image has a first magnetic resonance image weighting. The style magnetic resonance image has the second magnetic resonance image weighting. The autoencoder neural network is configured such that the anatomical structures in the target magnetic resonance image match anatomical structures in the reference magnetic resonance image. The medical system further comprises a computational system. Execution of the machine-executable instructions causes the computational system to receive the reference magnetic resonance image. The reference magnetic resonance image is descriptive of a field of view of a subject. Execution of the machine-executable instructions further causes the computational system to receive measured k-space data. The measured k-space data is descriptive of the field of view of the subject. Execution of the machine-executable instructions further causes the computational system to reconstruct a measured magnetic resonance image from the measured k-space data. Execution of the machine-executable instructions further causes the computational system to provide the measured magnetic resonance image as the style magnetic resonance image.

Execution of the machine-executable instructions further causes the computational system to perform, as an iterative loop, the following steps at least once. These steps include to receive the target magnetic resonance image in response to inputting the reference magnetic resonance image and the style magnetic resonance image into the autoencoder neural network. These steps also include to calculate the target k-space data by Fourier transforming the target magnetic resonance image. These steps further include to generate intermediate k-space data by comparing the measured k-space data and the target k-space data. These steps further comprise to reconstruct an intermediate magnetic resonance image from the intermediate k-space data. These steps further comprise to use the intermediate magnetic resonance image and the style magnetic resonance image for the iterative loop. Execution of the machine-executable instructions further causes the computational system to provide the intermediate magnetic resonance image as a clinical magnetic resonance image upon termination of the iterative loop.

In another aspect a magnetic resonance imaging method that uses an autoencoder neural network is disclosed. The autoencoder neural network is configured to output a target magnetic resonance image with a second magnetic resonance image weighting in response to receiving a reference magnetic resonance image and a style magnetic resonance image as input. The reference magnetic resonance image has a first magnetic resonance image weighting. The style magnetic resonance image has the second magnetic resonance image weighting. The autoencoder neural network is configured such that the anatomical structures in the target magnetic resonance image match anatomical structures in the reference magnetic resonance image.

The method comprises receiving the reference magnetic resonance image. The reference magnetic resonance image is descriptive of a field of view of a subject. The method further comprises receiving measured k-space data. The measured k-space data is descriptive of the field of view of the subject. The method further comprises reconstructing a measured magnetic resonance image from the measured k-space data. The method further comprises providing the measured magnetic resonance image as the style magnetic resonance image.

The method further comprises the following steps at least once as an iterative loop. An iterative step includes receiving the target magnetic resonance image in response to inputting the reference magnetic resonance image and the style magnetic resonance image into the autoencoder neural network. An iterative step further comprises calculating target k-space data by Fourier transforming the target magnetic resonance image. The iterative steps further comprise generating intermediate k-space data by comparing the measured k-space data and the target k-space data. The iterative steps further comprise reconstructing an intermediate magnetic resonance image from the intermediate k-space data. The iterative steps further comprise using the intermediate magnetic resonance image as the style magnetic resonance image for the iterative loop. The iterative steps further comprise providing the intermediate magnetic resonance image as a clinical magnetic resonance image upon termination of the iterative loop.

In another aspect a computer program comprising machine-executable instructions configured for causing a computational system to perform the method of magnetic resonance imaging is disclosed.

BRIEF DESCRIPTION OF THE DRAWINGS

In the following preferred embodiments of the invention will be described, by way of example only, and with reference to the drawings in which:

    Fig. 1 illustrates an example of a medical system.
    Fig. 2 shows a flow chart which illustrates a method of using the medical system of Fig. 1.
    Fig. 3 illustrates a further example of a medical system that incorporates a magnetic resonance imaging system.
    Fig. 4 shows a comparison between several different image reconstruction algorithms.
    Fig. 5 illustrates an example of an autoencoder neural network.
    Fig. 6 illustrates the use of the decoder module of the autoencoder neural network of Fig. 5.
    Fig. 7 illustrates the encoder portion of a MUNIT neural network.
    Fig. 8 illustrates the decoder portion of a MUNIT neural network.
    Fig. 9 illustrates a further example of an autoencoder neural network.

DETAILED DESCRIPTION OF EMBODIMENTS

Like numbered elements in these figures are either equivalent elements or perform the same function. Elements which have been discussed previously will not necessarily be discussed in later figures if the function is equivalent.

In an example a medical system comprises a memory storing machine-executable instructions and also storing an autoencoder neural network. The autoencoder neural network is configured to output a target magnetic resonance image with a second magnetic resonance image weighting in response to receiving a reference magnetic resonance image and a style magnetic resonance image as input. The reference magnetic resonance image has a first magnetic resonance image weighting. The style magnetic resonance image has the second magnetic resonance image weighting.

The first magnetic resonance image weighting and the second magnetic resonance image weighting are labels which refer to two separate magnetic resonance image weightings. A magnetic resonance image weighting as used herein encompasses the type of data which is encoded into the magnetic resonance image. For example, magnetic resonance images may have a T1 weighting, a T2 weighting, a T2-star weighting, a proton density or other weighting. The term 'image weighting' may also be used interchangeably with the term 'contrast'. The use of the word 'contrast' in this context is however different than the normal use used in image processing. Typically, when discussing the type of contrast for a magnetic resonance image it means the type of protocol or the type of data which is displayed in the magnetic resonance image.

The autoencoder neural network is configured such that the anatomical structures in the target magnetic resonance image match anatomical structures in the reference magnetic resonance image. Often times when magnetic resonance images for the same anatomical region are acquired using different image weighting or contrasts or protocols some of the same anatomical structures are shown. The autoencoder neural network uses the style magnetic resonance image to define the modality or type of image for a particular magnetic resonance imaging protocol and the reference magnetic resonance image provides the anatomical data.

Execution of the machine-executable instructions causes the computational system to receive the reference magnetic resonance image. The reference magnetic resonance image is descriptive of a field of view of a subject. The field of view is the region of the subject from which k-space data is acquired. That the reference magnetic resonance image is descriptive of a particular field of view of a subject means that this is the area which is described or imaged by the reference magnetic resonance image.

Execution of the machine-executable instructions further causes the computational system to receive measured k-space data. The measured k-space data is descriptive of the field of view of the subject. The measured k-space data and the reference magnetic resonance image are therefore descriptive of the same anatomical volume of the subject.

Execution of the machine-executable instructions further causes the computational system to reconstruct a measured magnetic resonance image from the measured k-space data. The measured magnetic resonance image and the reference magnetic resonance image therefore nominally image the same volume of the subject. Execution of the machine-executable instructions further causes the computational system to provide the measured magnetic resonance image as the style magnetic resonance image. An iterative loop is performed in the first pass through the loop; the measured magnetic resonance image is used as the style magnetic resonance image.

Execution of the machine-executable instructions further causes the computational system to perform, as an iterative loop, the following steps at least once. The iterative steps include receiving the target magnetic resonance image in response to inputting the reference magnetic resonance image and the style magnetic resonance image into the autoencoder neural network. The iterative steps also include calculating target k-space data by Fourier transforming the target magnetic resonance image. In the case of parallel magnetic resonance imaging, this step may include artificially generating coil specific target k-space data to compare against the measured k-space data for each of the individual coil elements.

The iterative steps further comprise generating intermediate k-space data by comparing the measured k-space data and the target k-space data. The iterative steps further comprise reconstructing an intermediate magnetic resonance image from the intermediate k-space data. The iterative steps further comprise using the intermediate magnetic resonance image as the style magnetic resonance image for the iterative loop.

The intermediate magnetic resonance image replaces the current style magnetic resonance image for the next loop in the iterations. The iterative loop may be performed for example only once, it may be performed until there is a convergence, or it may be performed a predetermined number of times. When the iterative loop is finished the following step is performed. In this step execution of the machine-executable instructions further causes the computational system to provide the intermediate magnetic resonance image as a clinical magnetic resonance image upon termination of the iterative loop.

Examples may be beneficial because it may provide for an improved means of removing image artifacts or assisting in the reconstruction of a clinical magnetic resonance image. In this method, steps very similar to a compressed sensing reconstruction are performed. Normally in compressed sensing the k-space data is undersampled. The image is reconstructed and then it is typically filtered to remove incoherent aliasing artifacts or noise like artifacts and this filtered image then goes through a data consistency step where it is compared to the original k-space data and the resulting image is then used to reconstruct another image, which goes through this iterative process until some of the unsampled k-space data is recovered and there is an improvement in image quality. In the above method, instead of using a filter the autoencoder neural network takes anatomical data from the reference magnetic resonance image and uses this in reconstructing the target magnetic resonance image. This algorithm may be used in a variety of situations. It may be used for a compressed sensing reconstruction where the measured magnetic resonance image has been undersampled. In some instances, there may be image artifacts or other problems with the measured magnetic resonance image. The method will therefore also provide for the removal of image artifacts and improve the image quality of the clinical magnetic resonance image.

In another example, the autoencoder comprises a split encoder module. The split encoder module comprises a discreet content encoder module configured for outputting at least one spatial map in response to receiving the reference magnetic resonance image as input. The at least one spatial map may contain anatomical data that is extracted from the reference magnetic resonance image. The split encoder module further comprises a discreet style encoder module that is configured for outputting a feature vector in response to receiving the style input magnetic resonance image as input. The feature vector in terms of the autoencoder may be thought of as selecting the particular contrast or image weighting for the target magnetic resonance image. The autoencoder further comprises a decoder module configured for outputting the target magnetic resonance image in response to receiving the at least one spatial map and the feature vector as input. In this embodiment there are two separate decoder modules used. One is for extracting anatomical data and the other is for extracting style or weighting of the image type. This example may be beneficial because it may provide a very effective and accurate means of generating the target magnetic resonance image.

In another embodiment the style encoder module is configured as a variational encoder. Variational encoders may be beneficial because they have a very structured input for the feature vectors. For example, it makes it possible to make predictable changes in the contrast of a magnetic resonance image by adding a displacement to the feature vector. Using a variational encoder may also have the benefit of reducing large variations in the target magnetic resonance image resulting in small changes in the feature vector. The use of a variational encoder may provide better image quality of the target magnetic resonance image as well as better predictability. During training the loss function can be weighted such that a distribution such as a Gaussian may be forced onto the distribution of the feature vector that is input into the style encoder.

In another example the decoder module is configured for modulating the at least one spatial map using the feature vector. The decoder module essentially takes the anatomical data contained in the at least one spatial map and then modulates it with the feature vector to produce the target magnetic resonance image with the second magnetic resonance image weighting.

In another example the autoencoder is a multimodal unsupervised image translation neural network (MUNIT). This example may be beneficial because during tests it was shown that this had a very effective means of generating the target magnetic resonance image and as a result the clinical magnetic resonance image.

In another example the autoencoder further comprises a single encoder module and a single decoder module. The single encoder module is configured for generating a latent space vector in response to receiving the reference magnetic resonance image and the style magnetic resonance image as input. Instead of having two distinct encoders there is a single encoder which receives both images. The single decoder module is configured for generating the target magnetic resonance image in response to receiving the latent space vector. This example may be beneficial because it may provide a means of generating the target magnetic resonance image with a simpler neural network architecture.

The single encoder module and the single decoder module may, for example, be implemented using a deep autoencoder with multiple hidden layers. The single encoder module may be configured such that the input layer is large enough to receive both the reference magnetic resonance image and the style magnetic resonance image. The single decoder module may be configured such that it can output an image the same size as reference magnetic resonance image.

The training data may for example be constructed using pairs of magnetic resonance images which have different image weightings (or "contrast" types). For example, a T1 weighted and a T2 weighted image acquired from the same field of view of the same subject may be collected. The T1 image may then have artificial noise or artifacts added to it. In this particular example, the T1 image with artificial noise is the style magnetic resonance image, the T2 image is the reference image, and the original T1 image is the ground truth image. Many such groups of images may be constructed and used as training data for the autoencoder neural network. This differs from some other examples in that it is not style transfer. During the training process the two different image weightings may have motion correction performed on them to align the anatomical structures in both images with each other.

In another example the generation of the intermediate k-space data by comparing the measured k-space data and the target k-space data is performed using a compressed sensing data consistency update. The algorithm typically used in compressed sensing algorithms may be used in this case to provide the intermediate k-space data.

In another example the generation of the intermediate k-space data comprises performing a motion correction between the measured k-space data and the target k-space data. This for example may be a rigid body correction that is performed between the measured k-space data and the target k-space data before the comparison or the data consistency update. For example, there could be an algorithm which fits the measured k-space data and the target k-space data and then performs rigid body translations in k-space to the target k-space data such that it has the same location as the measured k-space data. This may be beneficial because the subject may have moved slightly between the acquisition of the reference magnetic resonance image and the k-space data for the measured magnetic resonance image. Performing this motion correction may result in greatly superior results and a large improvement in the resulting clinical magnetic resonance image.

In another example the k-space data is fully sampled. This example may be beneficial because it may provide a means of providing for an improved clinical magnetic resonance image using a compressed sensing type algorithm even when the k-space data is fully sampled. It may for example provide a means of removing image artifacts or improving image quality. An advantage of this approach is that it may have the benefit of reducing the change that fake or artificial features are present in the clinical magnetic resonance image. Using neural networks for image processing may have the potential disadvantage of adding fake or hallucinated features to an image. The data consistency step where the intermediate k-space data is generated by comparing the measured k-space data and the target k-space data helps to ensure that the neural network does not introduce artifacts into the final clinical magnetic resonance image.

In another example, execution of the machine executable instructions further causes the computational system to determine a registration of the reference magnetic resonance image to the measured magnetic resonance image. This registration may be performed using algorithmic registration algorithms or neural networks. These types of algorithms are available and may for example be able to identify anatomical landmarks in both the reference magnetic resonance image and the measured magnetic resonance image. Execution of the machine executable instructions further causes the computational system to perform a rigid body or non-rigid (deformable) transformation of the reference magnetic resonance image using the registration before performing the iterative loop. In the case of a rigid body transformation a least squares fit, for example, may be used to translate and/or rotate the reference magnetic resonance image so that its location in the image matches or aligns with the anatomical markers of the measured magnetic resonance image. In the case of a deformable transformation the reference magnetic resonance image is deformed so that its anatomical markers are aligned with the anatomical markers of the measured magnetic resonance image. The advantage of this is that the target k-space data will be aligned with the measured k-space data during the iterative loops. The algorithm will perform better and account for subject motion between when the reference magnetic resonance image and the measured magnetic resonance image were acquired.

In another example the second k-space data is undersampled. This for example may provide for an improved means of performing a compressed sensing reconstruction.

In another example the machine-executable instructions further cause the computational system to receive reference k-space data. Execution of the machine-executable instructions further causes the computational system to reconstruct the reference input magnetic resonance image from the reference k-space data.

In another example the medical system further comprises a magnetic resonance imaging system. The memory stores reference pulse sequence commands configured for controlling the magnetic resonance imaging system to acquire the reference k-space data according to a reference magnetic resonance imaging protocol. The memory stores subsequent pulse sequence commands configured for controlling the magnetic resonance imaging system to acquire the measured k-space data according to a subsequent magnetic resonance imaging protocol. Execution of the machine-executable instructions further causes the computational system to control the magnetic resonance imaging system with the reference pulse sequence commands to acquire the reference k-space data from the field of view. Execution of the machine-executable instructions further causes the computational system to control the magnetic resonance imaging system with the subsequent pulse sequence commands to acquire the measured k-space data from the field of view. This embodiment may be beneficial because the reference k-space data and the measured k-space data are acquired from the same field of view in a short or limited time. This may help to ensure that the reference k-space data and the measured k-space data are obtained from the same or closely identical anatomical region of the subject. This may for example improve the resulting clinical magnetic resonance image.

In another example the iterative loop is performed either as a single time, until a predetermined image convergence criterion for subsequent iterations of the intermediate magnetic resonance image is met, and a predetermined number of times. For example, an image metric or image comparison could be used to calculate a value for a convergence factor.

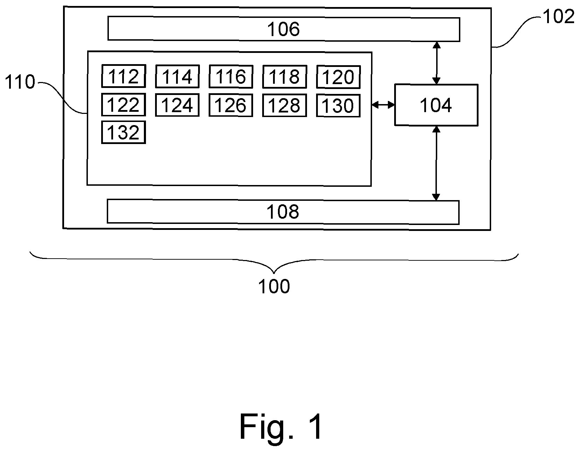

Fig. 1 illustrates an example of a medical system 100. The medical system 100 is shown as comprising a computer 102. The computer 102 may for example represent one or more computers located at one or more locations. The computer 102 could in different examples be a workstation in a radiology department, a computer used for controlling a magnetic resonance imaging system, or a cloud-based or remote server configured for providing image reconstruction services. The computer 102 is shown as comprising a computational system 104. The computational system 104 may represent one or more computational systems or cores located at one or more locations. The computational system 104 is shown as being in communication with an optional hardware interface 106 and an optional user interface 108. The hardware interface 106 may enable the computational system 104 to communicate with and/or control other components of the medical system 100 if they are present. For example, the hardware interface 106 could be used to control and communicate with a magnetic resonance imaging system. The user interface 108 may be used by an operator or user to control the operation and function of the medical system 100.

The computational system 104 is further shown as being in communication with a memory 110. The memory 110 is intended to represent various types of memory which are accessible to the computational system 104. In one example the memory 110 is a non-transitory storage medium.

The memory 110 is shown as storing machine-executable instructions 112 and an autoencoder neural network 114. The machine-executable instructions 112 contain instructions which enable the computational system 104 to perform various computational and image processing tasks. It also may enable the computational system 104 to control other components such as a magnetic resonance imaging system. The autoencoder neural network 114 is configured to receive a reference magnetic resonance image 116 and a style magnetic resonance image 122 and in response output a target magnetic resonance image 124. The memory 110 is further shown as containing measured k-space data 118. The memory 110 is further shown as containing a measured magnetic resonance image 120 that was reconstructed from the measured k-space data. In an iterative loop in the first loop the measured magnetic resonance image 120 is used as a style magnetic resonance image 122. The style magnetic resonance image 122 provides the image weighting or contrast type of the target magnetic resonance image 124. The memory 110 is further shown as containing the target magnetic resonance image 124 that was received in response to inputting the style magnetic resonance image 122 and the reference magnetic resonance image 116 into the autoencoder neural network 114.

The memory 110 is further shown as containing a target k-space data 126 that was calculated by converting the target magnetic resonance image 124 into k-space. The memory 110 is further shown as containing intermediate k-space data 128 that was determined or calculated by comparing the target k-space data 126 to the measured k-space data 118. This may for example be achieved using a data consistency step as is performed in typical compressed sensing algorithms. In some instances, the target k-space data 126 is modified or transformed so that it matches the measured k-space data 118 before this comparison takes place. For example, the target k-space data 126 could be subjected to a rigid body transform so that it matches positionally the measured k-space data. The memory 110 is further shown as containing an intermediate magnetic resonance image 130 that was reconstructed from the intermediate k-space data 128. In the looped-based method the style magnetic resonance image 122 is then set to be equal to the current intermediate magnetic resonance image 130. If the iterative loop is finished, then the clinical magnetic resonance image 132 is then set as being equal to the current intermediate magnetic resonance image 130.

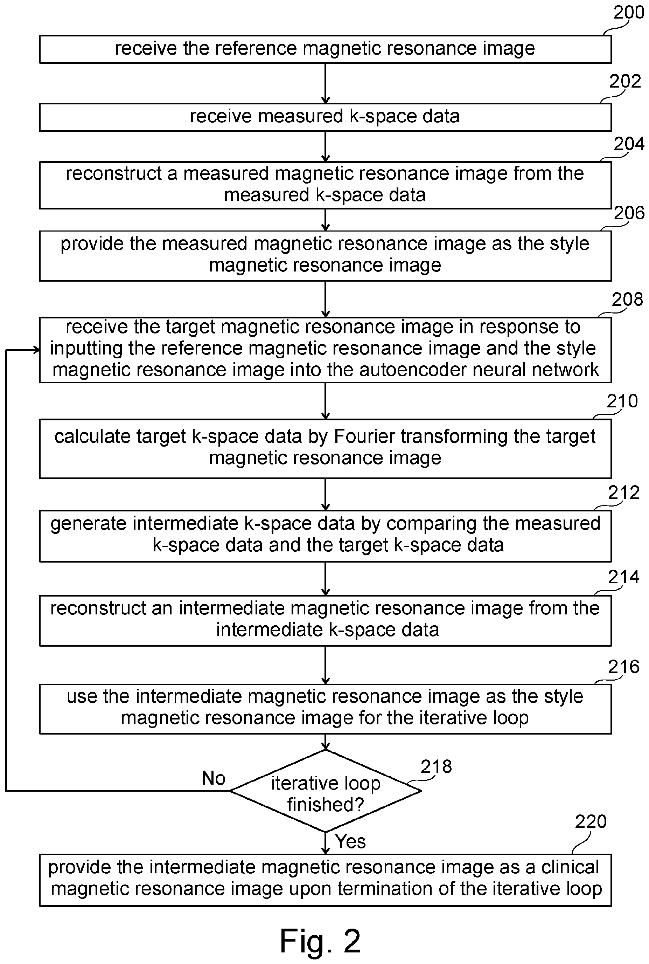

Fig. 2 shows a flowchart which illustrates a method of operating the medical system 100. In step 200 the reference magnetic resonance image 116 is received. The reference magnetic resonance image is descriptive of a field of view of a subject. In step 202, the measured k-space data 118 is received. The measured k-space data is descriptive of the same field of view of the subject. In step 204, the measured magnetic resonance image 120 is reconstructed from the measured k-space data 118. In step 206, the measured magnetic resonance image 120 is provided as the style magnetic resonance image 122. Steps 208, 210, 212, 214, and 216 form an iterative loop. These steps may be performed only once, or they may be performed multiple times to iteratively reconstruct the clinical magnetic resonance image 132. In the first pass through the loop the measured magnetic resonance image 120 is the style magnetic resonance image 122. In step 208, the target magnetic resonance image 124 is received in response to inputting the reference magnetic resonance image 116 and the style magnetic resonance image 122 into the autoencoder neural network 114. In step 210, the target k-space data 126 is calculated by Fourier transforming the target magnetic resonance image 124.

In step 212, the intermediate k-space data 128 is generated by comparing the measured k-space data 118 and the target k-space data 126. In step 214, the intermediate magnetic resonance image 130 is reconstructed from the intermediate k-space data. If the loop is not finished, then step 216 is performed. In step 216 the intermediate magnetic resonance image 130 is used as the style magnetic resonance image 122 in the next iteration of the loop. Box 218 is a decision box, and the question is: is the iterative loop finished. If the answer is "yes" then the method proceeds to block 220 and the current intermediate magnetic resonance image 130 is provided as the clinical magnetic resonance image 132. If the answer to question block 218 is "no," then the intermediate magnetic resonance image is used as the style magnetic resonance image 122 for the next loop and the method proceeds to block 208. The steps 208, 210, 212, 214, and 216 are repeated until the loop is finished.

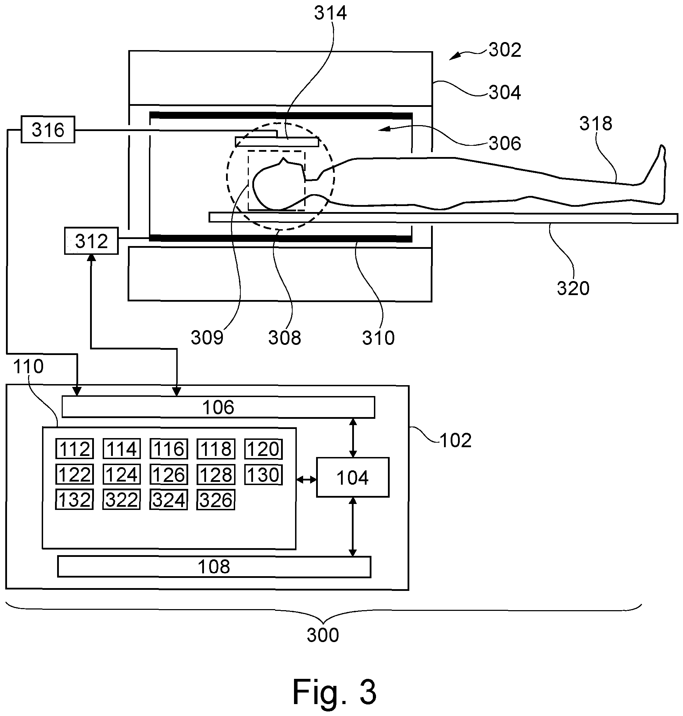

Fig. 3 illustrates a further example of a medical system 300. In this example the medical system 300 further comprises a magnetic resonance imaging system 302. The magnetic resonance imaging system 302 comprises a magnet 304. The magnet 304 is a superconducting cylindrical type magnet with a bore 306 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The measured k-space data is acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309. In this example, the head of the subject 318 is positioned within the field of view 309. The measured k-space data that will be acquired is therefore for performing a head or brain scan.

Within the bore 306 of the magnet there is also a set of magnetic field gradient coils 310 which is used for the acquisition of measured k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio frequency coil 314 is connected to a radio frequency transceiver 316. The radio frequency coil 314 and radio frequency transceiver 316 may be replaced by separate transmit and receive coils and a separate transmitter and receiver. It is understood that the radio frequency coil 314 and the radio frequency transceiver 316 are representative. The radio frequency coil 314 is intended to also represent a dedicated transmit antenna and a dedicated receive antenna. Likewise, the transceiver 316 may also represent a separate transmitter and receiver. The radio frequency coil 314 may also have multiple receive/transmit elements and the radio frequency transceiver 316 may have multiple receive/transmit channels. The transceiver 316 and the gradient controller 312 are shown as being connected to the hardware interface 106 of the computer system 102.

The memory 110 is further shown as containing reference pulse sequence commands 322. The memory 110 is further shown as containing reference k-space data 324 that was acquired by controlling the magnetic resonance imaging system 302 with the reference pulse sequence commands 322. The memory 110 is further shown as containing subsequent pulse sequence commands 326. The measured k-space data 118 was acquired by controlling the magnetic resonance imaging system with the subsequent pulse sequence commands 326.

As was mentioned above a MUNIT neural network may be used as the autoencoder neural network 114 for reconstruction. When using a MUNIT neural network one assumes that a pair of MR contrasts (MR images with different image weightings) of a given subject can be decomposed into "content" (the reference magnetic resonance image 116) and "style" representations (the measured magnetic resonance image 120), and seek to model this relationship with the MUNIT neural network via unpaired training. As an example, one may describe sets of T1w and T2w images (as the reference magnetic resonance image 116 and the measured magnetic resonance image 120) as image distributions and assume that contrast-independent anatomical information can be separated out as content from contrast-specific style variations -- properties of one image distribution which cannot be explained by the other distribution, such as the influence of MR acquisition settings. Therefore, training a model may use a large database of at least 2 MR contrasts. These scans may preferably be free from any post-reconstruction processing and may resemble (e.g. in terms of FOV, noise levels, etc.) images which are to be reconstructed during algorithm deployment.

The MUNIT-based reconstruction algorithm: Given a high-quality and spatially aligned T1w reference scan during the reconstruction of a T2w scan (example of an intermediate magnetic resonance image 130), the MUNIT-based denoising/artefact-removal operator simply replaces the artefact-heavy spatial content on the T2w (as an example of the measured magnetic resonance image 120) image estimate with the clean content maps from the T1w reference (as an example of the reference magnetic resonance image 116). Note that this works because the content maps are independent of the contrast, at least in theory. This idea forms the basis of one example algorithm.

Content refinement strategy: When the T1w content is identical to the ground truth T2w content, the algorithm can deliver extremely high-quality reconstructions. However, in practice, there may be some discrepancy between them due to misalignment between images, poor content preservation in MUNIT, etc. This discrepancy may lead to the denoised image conflicting with the acquired data and thereby degrading the reconstruction. Therefore, for practical scenarios, we would like the algorithm to be robust to imperfections in the deep learning model. To address this and to approach the image quality of the ideal content case, we propose the following strategy -- initialize the content estimate with T1w content (as an example of the reference magnetic resonance image 116) and iteratively refine it to adapt with the acquired raw data (the measured k-space data 118).

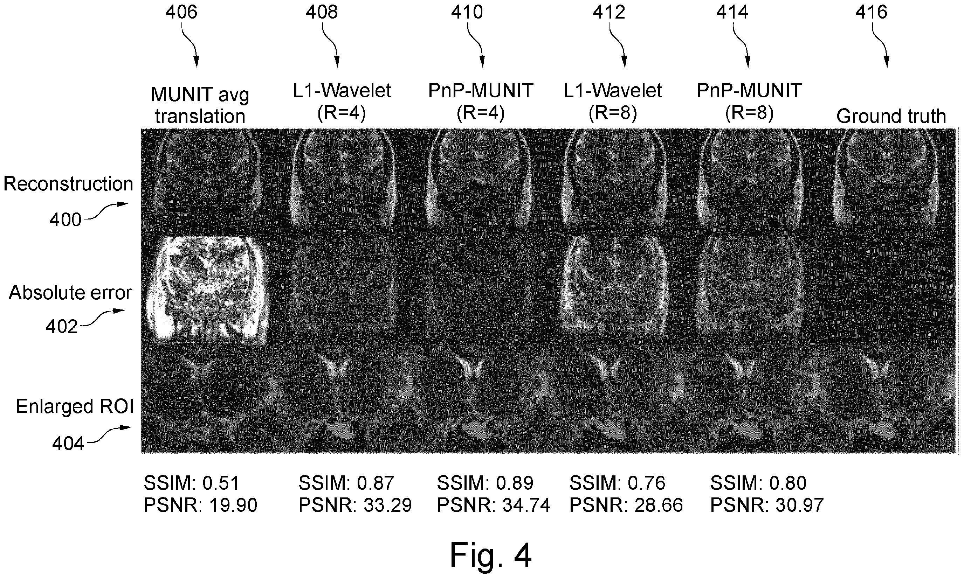

Fig. 4 shows the comparison between several different reconstruction algorithms. Row 400 shows the image reconstruction, row 402 shows the absolute error between the reconstruction 400 and a ground truth image in column 416. In order to show greater details an enlarged region of interest for each reconstruction method is shown is shown in row 404.

Column 406 shows a MUNIT average translation, this is purely a style transfer using a MUNIT neural network. The Absolution error for the MUNIT average translation is in row 402 and column 406. It can be seen that it does not match the ground truth image 416.

Column 408 shows an L1-wavelet reconstruction. Column 410 shows an example of a clinical magnetic resonance image 132 according to an example that uses a MUNIT neural network reconstructing under sampled k-space data. The images in row 410 may be considered to be a typical clinical magnetic resonance images reconstructed according to an example. Column 412 shows another L1-wavelet reconstruction with a higher degree of undersampling. Column 414 shows an additional MUNIT reconstruction of a clinical magnetic resonance image 132 with a higher degree of undersampling than in Fig. 410. It can be seen that in comparing these the images in column 410 are better than the images in column 408 and the images in column 414 are better than the images in column 412.

In Fig. 4, a T1w reference scan (not shown) was used to guide the reconstruction of a T2w scan (example of an intermediate magnetic resonance image 130) . The proposed method when a MUNIT neural network is used as the autoencoder neural network is termed PnP-MUNIT for this example. The results of the PnP-MUNIT algorithm 410, 414 was compared with two baseline algorithms - (a) MUNIT translation which is merely the use the MUNIT image model to predict the T2w scan from the T1w reference scan taking into account no acquired raw T2w data as a style transfer 406, and (b) L1-Wavelet algorithm 408, 412 which is a conventional reconstruction baseline. The absolute error maps 402 were computed with respect to the ground-truth T2w reconstruction, and the enlarged ROI 404 is used to show the sharpness of the output reconstructions. Image quality was quantified with the Peak to Signal noise ratio (PSNR) and Structural Similarity Index Measure (SSIM) metrics whose high values indicate better quality.

In one example there is a guided reconstruction problem wherein given a high-quality scan of a certain "contrast" (say T1W) is used as a prior (reference magnetic resonance image 116) to guide the reconstruction of an undersampled second scan (the style magnetic resonance image 122) of another "contrast" (say T2W) of the same patient.

Examples may a solution to the aforementioned problem and is made of 2 main components:

1. Content/style model: This is a deep learning-based technique from computer vision literature, known as MUNIT (Multimodal UNsupervised Image Translation), for learning semantically meaningful relationship between 2 given collections (or "domains") of images. In this context, the information shared between the 2 protocols, represented explicitly, is termed "content", whereas the protocol-specific information, also represented explicitly, is termed "style". In our invention, given a dataset of images from 2 MRI protocols (e.g. T1W and T2W), the first step is to train such a model.

2. Iterative reconstruction: We then plug in the learned content/style model into a compressed-sensing-like iterative reconstruction algorithm. The model acts may act a powerful artifact-removal operator. It uses the clean content information from the reference scan to remove undersampling artifacts from the reconstruction. A data-consistency update step then ensures that this clean reconstruction image does not stray too far from the acquired undersampled data.

When implemented using a MUNIT neural network, it comprises a system of 2 coupled autoencoder networks, one corresponding to each domain (style and content). As shown in the figure, each autoencoder learns to transform an image into a latent code composed of a content part and a style part.

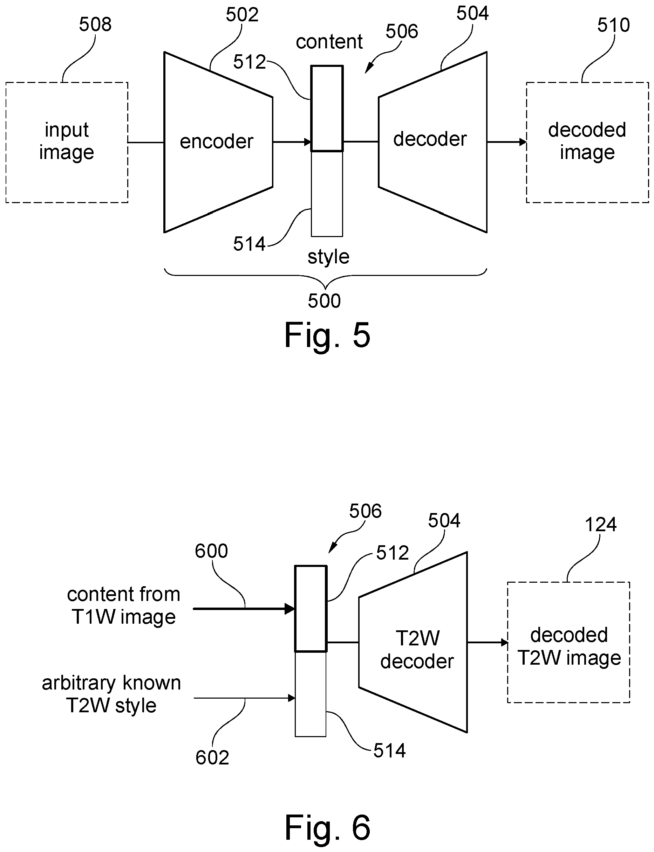

Fig. 5 illustrates an example of an autoencoder neural network 500. There is a single encoder module 502 and a single decoder module 504. There is a latent space vector 506 that in this example is divided into a content portion and a style portion 514. In this example there is a single input image 508 which is then reproduced as a decoded image 510.

It is the content part of the latent code (latent space vector 506) that is trained to represent the information shared between the 2 domains via a coupling mechanism, described later in Section IV. The training stage does not require paired data, meaning that in order to train the model on, say, T1W and T2W scans the training dataset is not required to contain aligned T1W -T2W pairs of each patient.

Once a model is trained and a pair of T1W-T2W scans is provided and their latent content codes computed, the content part of the T1W latent code and that of the T2W latent code will be similar to the degree that they would be interchangeable. This allows one to synthesize using the decoder a T2W image knowing the content of the corresponding T1W image, as shown in Fig. 6.

In Fig. 6 the same single decoder module 504 from Fig. 5 is fed with a content portion 600 from a T1-weighted image and a style portion 602 from a T2-weighted image. It then produces a target image 124 which is a decoded T2-weighted image.

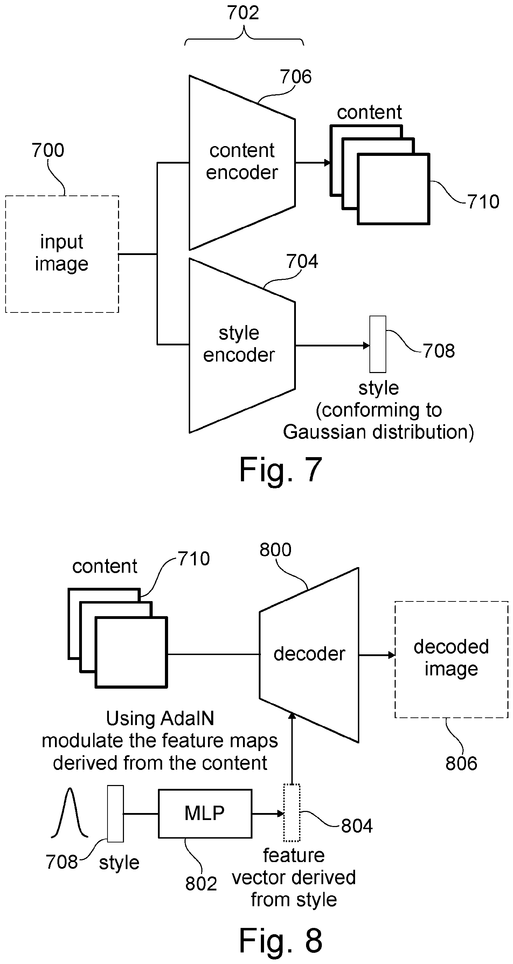

The specific network architectures used to implement the aforementioned abstract blueprint of the autoencoder depends on the specifics of the application. In general, it is beneficial, but not necessary, to represent the content part of the latent code separately as a spatial map in order to easily learn domain-independent spatial features from the images. Meanwhile, the style part may be simply represented as a generic feature vector giving it the more freedom to encode arbitrary factors of variation in the image distributions. One may also train the style code to conform to a known distribution (typically Gaussian), so that one can sample arbitrary styled synthetic images during inference (as is the case in variational autoencoders). Given these requirements, the encoder can be constructed using convolutional blocks with separate networks for the content and style parts, as shown in Figs. 7 and 8.

Fig. 7 illustrates the training using a single input image 700. There is a split encoder module 702 which comprises a discreet content encoder 706 and a discreet style encoder 704. The discreet style encoder 704 generates a feature vector 708 and the discreet content encoder 706 generates a spatial map 710.

On the decoder side, the a feature that may be used to effectively inject style is the adaptive instance normalization (AdaIN) mechanism. This is implemented using 2 parts: (1) an MLP that maps the Gaussian-priored style vector into a disentangled feature vector (as shown in the StyleGAN paper) and (2) the AdaIN layers in the decoder which, using this style information, modify the statistics of the convolutional feature maps derived from the content. This is shown in the following figure:

Fig. 8 illustrates the decoder module 800 for the MUNIT algorithm. The decoder module 800 receives a spatial map 710 and a feature vector 804 derived from the style 708. This transformation is performed by the MuLtilayer Perceptron (MLP) module 802. The feature vector 804 modulates the spatial map 710 using the decoder 800 to produce the decoded image 806 which is equivalent to the target magnetic resonance image 124.

The MUNIT neural network learns the content/style relationship between 2 distributions of image data in an unsupervised way. As such, one need not expend effort in spatially aligning the T1W and T2W of every patient in the training set and allowing even those patients for whom only one scan is available and not the other.

At its core, MUNIT is an image-to-image translation technique. Unsupervised training is made possible with the use of adversarial learning. Instead of relying on a ground-truth target image as in a supervised scenario, MUNIT uses one discriminator per domain to compare not the individual synthetic image with an individual true image, but instead the distribution of the synthetic images with the distribution of the true images (thus requiring absolutely no correspondence between the individual samples of the true and the synthetic distributions). This leads to the use of the following adversarial loss term:

$$\mathcal{L}^{x_2}_{GAN} = \mathbb{E}_{x_{1\rightarrow2}}[log(1 - D^2(x_{1\rightarrow2}))] + \mathbb{E}_{x_2}[logD^2(x_2)]$$

$$\mathcal{L}^{x_1}_{GAN} = \mathbb{E}_{x_{2\rightarrow1}}[log(1 - D^1(x_{2\rightarrow1}))] + \mathbb{E}_{x_1}[logD^1(x_1)]$$

$$\mathcal{L}_{GAN} = \mathcal{L}^{x_1}_{GAN} + \mathcal{L}^{x_2}_{GAN}$$

Because MUNIT is also a system of 2 autoencoders 704, 706, one feature is that the latent code (content and style together) encode the input image with minimum information loss. This is ensured by the image recovery loss term:

$$\mathcal{L}^{x_1}_{rec} = \mathbb{E}_{x_1}[\|G^1(E^1_c(x_1), E^1_s(x_1)) - x_1\|_1]$$

$$\mathcal{L}^{x_2}_{rec} = \mathbb{E}_{x_2}[\|G^2(E^2_c(x_2), E^2_s(x_2)) - x_2\|_1]$$

$$\mathcal{L}^{image}_{rec} = \mathcal{L}^{x_1}_{rec} + \mathcal{L}^{x_2}_{rec}$$

Now, what differentiates the content from the style during the learning process (i.e. making the content encode domain-independent information and style encode the domain-specific information) is a mechanism that couples the 2 autoencoders with each other. Specifically, the content code extracted from the T1W image (the reference magnetic resonance image 122) is combined with a Gaussian-sampled style code to form a valid T2W image (the intermediate magnetic resonance image 130) . Following this, this valid synthetic T2W image is split back into content and style. Now, content and style preservation in this T1W-to-T2W translation process is defined by saying that the content and style codes which the synthetic T2W image was decomposed into must be close to the content and style codes which had composed the synthetic T2W earlier. This is condition, applied both to the T1W-to-T2W and the T2W-to-T2W direction, is expressed via the content and style recovery loss terms:

$$\mathcal{L}^{c_1}_{rec} = \mathbb{E}_{c_1,s_2}[\|E^2_c(G^2(c_1, s_2)) - c_1\|_1]$$

$$\mathcal{L}^{c_2}_{rec} = \mathbb{E}_{c_2,s_1}[\|E^1_c(G^1(c_2, s_2)) - c_2\|_1]$$

$$\mathcal{L}^{content}_{rec} = \mathcal{L}^{c_1}_{rec} + \mathcal{L}^{c_2}_{rec}$$

$$\mathcal{L}^{s_1}_{rec} = \mathbb{E}_{c_2,s_1}[\|E^1_c(G^1(c_2, s_1)) - s_1\|_1]$$

$$\mathcal{L}^{s_2}_{rec} = \mathbb{E}_{c_1,s_2}[\|E^2_c(G^2(c_1, s_2)) - s_2\|_1]$$

$$\mathcal{L}^{style}_{rec} = \mathcal{L}^{s_1}_{rec} + \mathcal{L}^{s_2}_{rec}$$

Thus, finally, one has the following expression for the total loss:

$$\mathcal{L} = \mathcal{L}_{GAN} + \lambda_1 \mathcal{L}_{rec}^{image} + \lambda_2 \mathcal{L}_{rec}^{content} \lambda_3 \mathcal{L}_{rec}^{style}$$

where $\lambda 1, \lambda 2, \lambda 3$ are the manually adjusted hyperparameters. During training, this total loss is minimized and all networks, including the discriminators, are trained jointly.

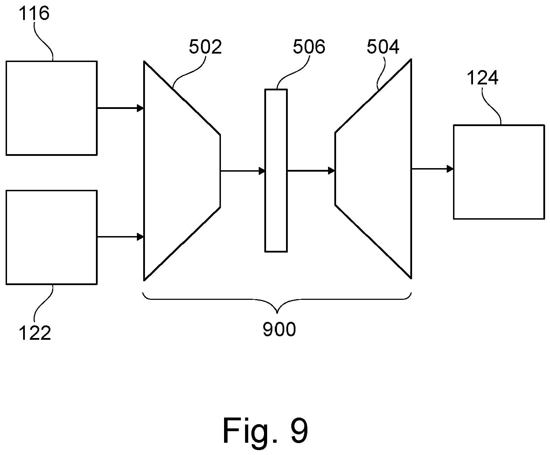

Fig. 9 illustrates a further example of an autoencoder neural network 900. There is a single encoder module 502 and a single decoder module 504. In this example the latent space vector 506 is not divided into a content portion 512 and a style portion 514. The single encoder module 502 is trained, as was described above, to provide a single latent space vector. In this example the autoencoder is a conventional autoencoder and is not a specialized neural network for style transfer.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the

**EP 4 549 983 A1**

word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

100 medical system
102 computer
104 computational system
106 optional hardware interface
108 optional user interface
110 memory
112 machine executable instructions
114 autoencoder neural network
116 reference magnetic resonance image
118 measured k-space data
120 measured magnetic resonance image
122 style magnetic resonance image
124 target magnetic resonance image
126 target k-space data
128 intermediate k-space data
130 intermediate magnetic resonance image
132 clinical magnetic resonance image
200 receive the reference magnetic resonance image
202 receive measured k-space data
204 reconstruct a measured magnetic resonance image from the measured k-space data
206 provide the measured magnetic resonance image as the style magnetic resonance image
208 receive the target magnetic resonance image in response to inputting the reference magnetic resonance image and the style magnetic resonance image into the autoencoder neural network
210 calculate target k-space data by Fourier transforming the target magnetic resonance image
212 generate intermediate k-space data by comparing the measured k-space data and the target k-space data
214 reconstruct an intermediate magnetic resonance image from the intermediate k-space data
216 use the intermediate magnetic resonance image as the style magnetic resonance image for the iterative loop
218 iterative loop finished?
220 provide the intermediate magnetic resonance image as a clinical magnetic resonance image upon termination of the iterative loop
300 medical system
302 magnetic resonance imaging system
304 magnet
306 bore of magnet
308 imaging zone
309 field of view
310 magnetic field gradient coils
312 magnetic field gradient coil power supply
314 radio frequency coil
316 transceiver
318 subject
320 subject support
322 reference pulse sequence commands
324 reference k-space data
326 subsequent pulse sequence commands
500 autoencoder neural network

13

502     single encoder module
504     single decoder module
506     latent space vector
508     input image
510     decoded image
512     content portion
514     style portion
702     split encoder module
704     discrete style encoder
706     discrete content encoder
708     feature vector
710     spatial map
800     decoder module
802     MLP
804     feature vector derived from style
806     decoded image / target magnetic resonance image

**Claims**

1.  A medical system (100, 300) comprising:

    - a memory (110) storing machine executable instructions (112) and an autoencoder neural network (114, 500, 702, 800, 900), wherein the autoencoder neural network is configured to output a target magnetic resonance image (124) with a second magnetic resonance image weighting in response to receiving a reference magnetic resonance image (116) and a style magnetic resonance image (122) as input, wherein the reference magnetic resonance image has a first magnetic resonance image weighting, wherein the style magnetic resonance image has the second magnetic resonance image weighting, wherein the autoencoder neural network is configured such that anatomical structures in the target magnetic resonance image match anatomical structures in the reference magnetic resonance image; and
    - a computational system (122), wherein execution of the machine executable instructions causes the computational system to:

      - receive (200) the reference magnetic resonance image (116), wherein the reference magnetic resonance image is descriptive of a field of view (309) of a subject (318);
      - receive (202) measured k-space data (118), wherein the measured k-space data is descriptive of the field of view of the subject, and
      - reconstruct (204) a measured magnetic resonance image (120) from the measured k-space data;
      - provide (206) the measured magnetic resonance image as the style magnetic resonance image;

    wherein execution of the machine executable instructions further causes the computational system to perform, as an iterative loop, the following at least once:

      - receive (208) the target magnetic resonance image in response to inputting the reference magnetic resonance image and the style magnetic resonance image into the autoencoder neural network;
      - calculate (210) target k-space data (126) by Fourier transforming the target magnetic resonance image;
      - generate (212) intermediate k-space data (128) by comparing the measured k-space data and the target k-space data; and
      - reconstruct (214) an intermediate magnetic resonance image (130) from the intermediate k-space data;
      - use (216) the intermediate magnetic resonance image as the style magnetic resonance image for a next iteration of the iterative loop;

    wherein execution of the machine executable instructions further causes the computational system to provide (218) the intermediate magnetic resonance image as a clinical magnetic resonance image (132, 410, 414) upon termination of the iterative loop.

2.  The medical system of claim 1, wherein the autoencoder comprises a split encoder module (702), wherein the split encoder module comprises a discrete content encoder module (706) configured for outputting at least one spatial map (710) in response to receiving the reference magnetic resonance image as input, wherein the split encoder module comprises a discrete style encoder module (704) configured for outputting a feature vector (708) in response to receiving the style input magnetic resonance image as input, wherein the autoencoder further comprises a decoder module (800) configured for outputting the target magnetic resonance image in response to receiving the at least one spatial map and the feature vector as input.

3. The medical system of claim 2, wherein the style encoder module is configured as a variational encoder.

4. The medical system of claim 2 or 3, wherein the decoder module is configured for modulating the at least one spatial map using the feature vector.

5. The medical system of any one of the preceding claims, wherein the autoencoder is a multimodal unsupervised image translation neural network.

6. The medical system of claim 1, wherein the autoencoder neural network (900) comprises a single encoder module (502) and a single decoder module (504), and wherein the single encoder module is configured for generating a latent space vector (506) in response to receiving the reference magnetic resonance image and the style magnetic resonance image as input, and wherein the single decoder module is configured for generating the target magnetic resonance image in response to receiving the latent space vector.

7. The medical system of any one of the preceding claims, wherein generation of the intermediate k-space data by comparing the measured k-space data and the target k-space data is performed using a compressed sensing data consistency update.

8. The medical system of claim 7, wherein the generation of the intermediate k-space data comprises performing a motion correction between the measured k-space data and the target k-space data before performing the compressed sensing data consistency update.

9. The medical system of any one of the preceding claims, wherein the second k-space data is fully sampled.

10. The medical system of any one of the preceding claims, wherein execution of the machine executable instructions further causes the computational system to:

    - determine a registration of the reference magnetic resonance image to the measured magnetic resonance image; and
    - perform a rigid or non-rigid transformation of the reference magnetic resonance image using the registration before performing the iterative loop.

11. The medical system of any one of the preceding claims, wherein execution of the machine executable instructions further causes the computational system to:

    - receive (324) reference k-space data; and
    - reconstruct the reference input magnetic resonance image from the reference k-space data.

12. The medical system of claim 10, wherein the medical system further comprises a magnetic resonance imaging system (302), wherein the memory stores reference pulse sequence commands (322) configured for controlling the magnetic resonance imaging system to acquire the reference k-space data according to a reference magnetic resonance imaging protocol, wherein the memory stores subsequent pulse sequence commands (326) configured for controlling the magnetic resonance imaging system to acquire the measured k-space data according to a subsequent magnetic resonance imaging protocol, wherein execution of the machine executable instructions further causes the computational system to:

    - control the magnetic resonance imaging system with the reference pulse sequence commands to acquire the reference k-space data from the field of view; and
    - control the magnetic resonance imaging system with the subsequent pulse sequence commands to acquire the measured k-space data from the field of view.

13. The medical system of any one of the preceding claims, wherein the iterative loop is performed any one of the following: a single time, until a predetermined image convergence criterion for subsequent iterations of the intermediate magnetic resonance image is met, and a predetermined number of times.

14. A magnetic resonance imaging method using an autoencoder neural network (114, 500, 702, 800, 900), wherein the autoencoder neural network is configured to output a target magnetic resonance image (124) with a second magnetic resonance image weighting in response to receiving a reference magnetic resonance image (116) and a style magnetic resonance image (122) as input, wherein the reference magnetic resonance image has a first magnetic resonance image weighting, wherein the style magnetic resonance image has the second magnetic resonance image weighting, wherein the autoencoder neural network is configured such that anatomical structures in the target magnetic resonance image match anatomical structures in the reference magnetic resonance image, wherein the method comprises:

- receiving (200) the reference magnetic resonance image, wherein the reference magnetic resonance image is descriptive of a field of view (309) of a subject (318);
- receiving (202) measured k-space data (118), wherein the measured k-space data is descriptive of the field of view of the subject,
- reconstructing (204) a measured magnetic resonance image (120) from the measured k-space data; and
- providing (206) the measured magnetic resonance image as the style magnetic resonance image;
wherein the method further comprises performing, as an iterative loop, the following at least once:

- receiving (208) the target magnetic resonance image in response to inputting the reference magnetic resonance image and the style magnetic resonance image into the autoencoder neural network;
- calculating (210) target k-space data (126) by Fourier transforming the target magnetic resonance image;
- generating (212) intermediate k-space data (128) by comparing the measured k-space data and the target k-space data; and
- reconstructing (214) an intermediate magnetic resonance image (130) from the intermediate k-space data;
- using (216) the intermediate magnetic resonance image as the style magnetic resonance image for the iterative loop; and

wherein the method further comprises providing (218) the intermediate magnetic resonance image as a clinical magnetic resonance image upon termination (132, 410, 414) of the iterative loop.

15. A computer program comprising machine executable instructions configured for causing a computational system to perform the method of claim 13.

| | | | | | | | | | | | |
|---|---|---|---|---|---|---|---|---|---|---|---|
| 112 | 114 | 116 | 118 | 120 | | | | | | | |
| 122 | 124 | 126 | 128 | 130 | | | | | | | |
| 132 | | | | | | | | | | | |

Fig. 1

200

receive the reference magnetic resonance image

202

receive measured k-space data

204

reconstruct a measured magnetic resonance image from the measured k-space data

206

provide the measured magnetic resonance image as the style magnetic resonance image

208

receive the target magnetic resonance image in response to inputting the reference magnetic resonance image and the style magnetic resonance image into the autoencoder neural network

210

calculate target k-space data by Fourier transforming the target magnetic resonance image

212

generate intermediate k-space data by comparing the measured k-space data and the target k-space data

214

reconstruct an intermediate magnetic resonance image from the intermediate k-space data

216

use the intermediate magnetic resonance image as the style magnetic resonance image for the iterative loop

No ← iterative loop finished? 218

Yes

220

provide the intermediate magnetic resonance image as a clinical magnetic resonance image upon termination of the iterative loop

Fig. 2

Fig. 3

**Fig. 4**

Fig. 5

Fig. 6

702

706

700

content

content
encoder

710

input
image

704

style
encoder

708

style
(conforming to
Gaussian distribution)

## Fig. 7

content 710

800

decoder

decoded
image

806

Using AdaIN
modulate the feature maps
derived from the content

MLP

804

708 style

802

feature
vector derived
from style

## Fig. 8

Fig. 9

Europäisches
Patentamt

European
Patent Office

Office européen
des brevets

# EUROPEAN SEARCH REPORT

**Application Number**

EP 24 15 8606

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FENG CHUN-MEI ET AL: "Multimodal Transformer for Accelerated MR Imaging", IEEE TRANSACTIONS ON MEDICAL IMAGING, IEEE, USA, vol. 42, no. 10, 15 June 2022 (2022-06-15) , pages 2804-2816, XP011950234, ISSN: 0278-0062, DOI: 10.1109/TMI.2022.3180228 [retrieved on 2022-06-15] * the whole document * | 1-15 | INV. G01R33/56 G06N3/0455 |
| X | XIAO LIU ET AL: "Learning Disentangled Representations in the Imaging Domain", ARXIV.ORG, CORNELL UNIVERSITY LIBRARY, 201 OLIN LIBRARY CORNELL UNIVERSITY ITHACA, NY 14853, 29 July 2022 (2022-07-29), XP091282977, DOI: 10.1016/J.MEDIA.2022.102516 * the whole document * | 1-15 | |
| X | YUDA BI: "Exploring the Power of Generative Deep Learning for Image-to-Image Translation and MRI Reconstruction: A Cross-Domain Review", ARXIV.ORG, CORNELL UNIVERSITY LIBRARY, 201 OLIN LIBRARY CORNELL UNIVERSITY ITHACA, NY 14853, 16 March 2023 (2023-03-16), XP091464224, * the whole document * | 1-15 | **TECHNICAL FIELDS SEARCHED (IPC)** G01R G06N |
| X | CN 116 664 605 B (UNIV KUNMING SCIENCE & TECHNOLOGY; UNIV CHONGQING) 10 October 2023 (2023-10-10) * the whole document * | 1-15 | |

The present search report has been drawn up for all claims

| Place of search | Date of completion of the search | Examiner |
|---|---|---|
| Munich | 1 August 2024 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 24 15 8606

This annex lists the patent family members relating to the patent documents cited in the above-mentioned European search report.
The members are as contained in the European Patent Office EDP file on
The European Patent Office is in no way liable for these particulars which are merely given for the purpose of information.

01-08-2024

| Patent document cited in search report | Publication date | Patent family member(s) | Publication date |
|---|---|---|---|
| CN 116664605 B | 10-10-2023 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 112700508 A